(19) Europäisches Patentamt

European Patent Office

Office européen des brevets

(11) **EP 1 598 674 B1**

(12) **EUROPÄISCHE PATENTSCHRIFT**

(45) Veröffentlichungstag und Bekanntmachung des Hinweises auf die Patenterteilung:
**23.08.2006 Patentblatt 2006/34**

(51) Int Cl.:
***G01R 31/02*** *(2006.01)*

(21) Anmeldenummer: **04450110.4**

(22) Anmeldetag: **18.05.2004**

(54) **Verfahren zum Anzeigen eines hochohmingen Erdschlusses in einem Drehstromnetz**

Method of displaying a high resistance ground leak in a three phase network

Méthode d'affichage de la terre à grande resistance dans un réseau triphasé

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**LV**

(43) Veröffentlichungstag der Anmeldung:
**23.11.2005 Patentblatt 2005/47**

(73) Patentinhaber: **Trench Austria GmbH**
**4060 Leonding (AT)**

(72) Erfinder: **Schinerl, Thomas**
**4050 Traun (AT)**

(74) Vertreter: **Weiser, Andreas**
**Patentanwalt Dr. Andreas Weiser**
**Hietzinger Hauptstrasse 4**
**1130 Wien (AT)**

(56) Entgegenhaltungen:
**EP-B- 0 812 427**

EP 1 598 674 B1

**Beschreibung**

Die vorliegende Erfindung betrifft Verfahren zum Anzeigen eines hochohmigen Erdschlusses in einem Drehstromnetz mit zumindest zwei Leitungsabgängen, das mit einer Erdschlußlöschspule zur Resonanzerdung des Sternpunktes betrieben wird.

Als hochohmige Erdschlüsse werden in der Technik Erdschlüsse mit einem Erdübergangswiderstand von mehr als 5 kΩ bezeichnet, im allgemeinen Sprachgebrauch auch bereits Erdschlüsse mit einem Erdübergangswiderstand von mehr als 1 kΩ, weil sie mit älteren Verfahren nicht mehr feststellbar sind. Hochohmige Erdschlüsse treten beispielsweise auf, wenn ein umgestürzter Baum eine Leitung berührt (40 - 100 kΩ), ein Leiterseil nach einem Seilriß auf trockenen Sand, trockenen Felsen, Schnee oder Eis fällt, oder bei einem rückwärtigen Kabelbruch, bei welchem ein vom Verbraucher rückkehrendes Leiterseil zwar niederohmig die Erde berührt, jedoch von der Versorgerseite aus gesehen ein hochohmiger Erdschluß besteht, weil die Impedanz des verbraucherseitigen Transformators bzw. des Verbrauchers in den Erdschluß miteingeht.

Hochohmige Erdschlüsse sind in der Praxis sehr gefährlich. Zwar ist durch den hohen Widerstand der Strom an der Fehlerstelle reduziert, doch ergeben sich aus demselben Grund sehr hohe Schritt- und Berührspannungen. Gleichzeitig ist ein hochohmiger Erdschluß mit dem Auge kaum zu erkennen, weil der geringe Fehlerstrom keine mit dem Auge erkennbaren Schäden hervorruft.

Ein Verfahren der einleitend genannten Art ist aus der EP 0 812 427 bekannt und beruht auf einer Auswertung der Fehleradmittanzen der einzelnen Leitungsabgänge, welche mittels einer Überwachung der Verlagerungsspannung des Sternpunktes und der Nullströme der Leitungsabgänge im Zuge einer temporären Sternpunktbeaufschlagung ermittelt werden können. Der Abgang mit der größten Fehleradmittanz wird als erdschlußbehafteter Abgang angezeigt.

Auch wenn das Verfahren der EP 0 812 427 einen entscheidenden Durchbruch in der Schutztechnik darstellte, haben sich in der Praxis einige Nachteile gezeigt. So rufen z.B. laststromabhängige Meßfehler der zur Nullstromüberwachung eingesetzten Meßwandler scheinbare Nullströme auf den Leitungsabgängen hervor, welche unmittelbar in die Messung und damit das Auslösekriterium für eine Erdschlußanzeige eingehen. Genauso verfälschen unterschiedliche Längsimpedanzen ("Phasensplitting") der Leitungsabgänge bei Ringschaltungen oder fertigungsbedingte Toleranzen der Meßwandler das Auslösekriterium.

Zur Vermeidung von Fehlauslösungen müssen daher in der Praxis die Auslösekriterien des Verfahrens der EP 0 812 427 unempfindlicher eingestellt werden, als es seinem theoretischen Potential entsprechen würde. Ein weiteres Problem des bekannten Verfahrens ist, daß es bei manuellen Suchschaltungen, die ein Schließen von Leitungsringen oder Auftrennen von Leitungsabgängen erfordern, nicht mehr einsetzbar ist, da hier die ermittelte Leitungskapazität nicht mehr mit dem Referenzwert übereinstimmt. Der zusätzliche bzw. fehlende kapazitive Stromanteil geht direkt in die berechnete Fehleradmittanz ein, so daß unter Umständen der erdschlußbehaftete Abgang nicht mehr jener mit der größten Fehleradmittanz ist.

Die Erfindung setzt sich zum Ziel, ein Verfahren zum Anzeigen eines hochohmigen Erdschlusses in einem gelöschten Drehstromnetz mit zumindest zwei Leitungsabgängen zu schaffen, welches empfindlicher und zuverlässiger arbeitet als die bekannten Verfahren und darüber hinaus auch während manueller Suchschaltungen einsetzbar ist.

In einem ersten Aspekt der Erfindung wird dieses Ziel mit einem Verfahren der genannten Art erreicht, das sich auszeichnet durch die Schritte:

a) Ermitteln von Netzparametern umfassend zumindest eine auf die Unsymmetrie aller Leitungsabgänge zurückzuführende Netzunsymmetrieadmittanz und eine die Erdkapazität aller Leitungsabgänge berücksichtigende Netznulladmittanz anhand einer temporären Beaufschlagung des Sternpunktes und vektoriellen Messung seiner Verlagerungsspannung,

b) Speichern der Netzparameter oder der diesen zugrundeliegenden Werte als Referenzwerte,

c) Ermitteln einer auf einen allfälligen Erdschluß zurückzuführenden Netzfehleradmittanz anhand einer vektoriellen Messung der Verlagerungsspannung unter Zugrundelegung der Referenzwerte und, wenn die Netzfehleradmittanz einen vorgegebenen ersten Betrag überschreitet,

e) Anzeigen eines Erdschlusses.

Die Erfindung beruht auf einem völlig neuartigen Auslösekriterium für eine Erdschlußanzeige, und zwar der Auswertung einer "globalen" Netzfehleradmittanz, welche nicht mehr einem einzelnen Leitungsabgang zugeordnet ist, sondern dem gesamten Drehstromnetz mit allen Leitungsabgängen. Zur Ermittlung der Netzfehleradmittanz genügt es, die Verlagerungsspannung des Sternpunktes vektoriell zu messen und in ein Ersatzschaltbild "globaler" Netzparameter einzusetzen, welche die Netzabstimmung und die Netzunsymmetrie verkörpern. Die Netzparameter können durch eine temporäre Beaufschlagung des Sternpunktes ermittelt werden. Die Beaufschlagung des Sternpunktes kann auf beliebige Art und Weise erfolgen, beispielsweise durch eine vorübergehende Verstimmung der Erdschlußlöschspule, Beschaltung einer Hilfswicklung derselben, Beschaltung des Sternpunktes mit einer Hilfsimpedanz, direkte Stromeinspeisung in den Sternpunkt usw.

Das Verfahren der Erfindung benötigt für die Anzeige eines hochohmigen Erdschlusses keinerlei Meßwerte der Nullstromwandler der Leitungsabgänge, so daß Wandlerfehler und Lastströme das Auslösekriterium nicht beeinflussen können. Das erfindungsgemäße Verfahren ist damit wesentlich empfindlicher und zuverlässiger als alle bisher bekannten Verfahren.

Bevorzugt wird, wenn die Netzfehleradmittanz im Schritt c) den vorgegebenen ersten Betrag nicht überschreitet, das Verfahren ab Schritt c) wiederholt, wodurch eine kontinuierliche bzw. periodische Überwachung des Drehstromnetzes möglich ist. Beispielsweise kann die Verlagerungsspannung alle 20 ms gemessen und daraus die Netzfehleradmittanz ermittelt werden.

Gemäß einer besonders bevorzugten Ausführungsform des Verfahrens wird vorgesehen, daß nach Schritt c), wenn im Schritt c) die Netzfehleradmittanz den vorgegebenen ersten Betrag überschreitet, nur über den zusätzlichen Schritt:

d) neuerliches Ermitteln der Netzparameter und der Netzfehleradmittanz anhand einer neuerlichen temporären Beaufschlagung des Sternpunktes und vektoriellen Messung seiner Verlagerungsspannung und eines Vergleichs mit den Referenzwerten und, wenn die Netzfehleradmittanz einen vorgegebenen zweiten Betrag überschreitet, zu Schritt e) übergegangen wird. Dadurch kann im Falle einer - gleichsam "vorläufigen" - Erdschlußauslösung im Schritt c) nachgeprüft werden, ob die ermittelte Netzfehleradmittanz tatsächlich auf eine Änderung der Netzunsymmetrieadmittanz gegenüber den Referenzwerten zurückzuführen ist und/oder eine Änderung der Netznulladmittanz zugrunde liegt, wie sie beispielsweise durch das Zuschalten eines Leitungsabschnittes und der damit einhergehenden Änderung der Erdkapazität verknüpft ist. Dies kann insbesondere durch einen Vergleich der neu ermittelten Netzfehleradmittanz mit jener aus den gespeicherten Referenzwerten verifiziert werden, ähnlich wie es aus der EP 0 812 427 für die Verifizierung einer abgangsspezifischen Leitungsfehleradmittanz bekannt ist. Durch den zusätzlichen Verifikationsschritt d) ist das Verfahren der Erfindung unempfindlich gegenüber allfälligen Schaltvorgängen im Netz.

Optional kann dabei auch dann, wenn im Schritt d) die Netzunsymmetrieadmittanz einen vorgegebenen dritten Betrag überschreitet, zu Schritt e) übergegangen und die Erdschlußanzeige ausgelöst werden. Der dritte Betrag wird zweckmäßigerweise als Maximalwert gewählt, den die Netzunsymmetrieadmittanz niemals überschreiten darf, andernfalls sofort auf einen Erdschluß hingewiesen wird. Dadurch können insbesondere auch niederohmige Erdschlüsse erkannt werden.

Die Verifizierung der im Schritt c) vorläufig ermittelten Netzfehleradmittanz im Schritt d) beinhaltet eine Neuermittlung der Netzparameter und eröffnet damit die Möglichkeit, wenn offensichtlich kein Erdschluß vorliegt, das zugrundeliegende Netzmodell an den geänderten Netzzustand anzupassen. Zu diesem Zweck wird bevorzugt vorgesehen, daß, wenn im Schritt d) die Netzfehleradmittanz - und gegebenenfalls die Netzunsymmetrieadmittanz - ihre vorgegebenen zweiten bzw. dritten Beträge nicht überschreiten, das Verfahren ab Schritt b) wiederholt wird. Dadurch werden die zuletzt ermittelten Netzparameter als neue Referenzwerte gespeichert und das Referenz-Netzmodell wird nachgeführt, was eine fortgesetzte, periodische Überwachung ermöglicht.

Gemäß einem bevorzugten Merkmal der Erfindung kann dabei vorgesehen werden, daß auch dann, wenn im Schritt d) die Netzunsymmetrieadmittanz kleiner ist als ihr Referenzwert, das Verfahren ab Schritt b) wiederholt wird. Dies bewirkt eine Nachführung der Referenzwerte auch dann, wenn die Netzunsymmetrieadmittanz kleiner wird, was darauf hindeutet, daß das Verfahren offensichtlich zum Zeitpunkt des Vorliegens eines Erdschlusses begonnen worden ist. Durch diese Maßnahme wird das Auslösekriterium nach Beendigung des Erdschlusses selbsttätig rekalibriert.

Zu demselben Zweck kann auch vorgesehen werden, daß der über die Netzfehleradmittanz fließende Netzfehlerwirkstrom ermittelt wird und auch dann, wenn im Schritt d) der Netzfehlerwirkstrom in Bezug auf die Verlagerungsspannung negativ ist, das Verfahren ab Schritt b) wiederholt wird. Dieses Kriterium deutet wieder auf einen Verfahrensbeginn zum Zeitpunkt eines vorübergehenden, nun beendeten Erdschlusses hin.

Ein weiterer Aspekt der vorliegenden Erfindung besteht in der Schaffung eines Verfahrens zur Anzeige desjenigen Leitungsabganges, welcher von dem Erdschluß befallen ist. Diese Ausführungsform des erfindungsgemäßen Verfahrens zeichnet sich dadurch aus, daß für jeden einzelnen Leitungsabgang:

im Schritt a) Leitungsparameter umfassend jeweils zumindest eine auf die Unsymmetrie des Leitungsabgangs zurückzuführende Leitungsunsymmetrieadmittanz anhand der temporären Beaufschlagung des Sternpunktes und einer vektoriellen Messung des Summenstromes des Leitungsabgangs ermittelt werden,
im Schritt b) die Leitungsparameter als Referenzwerte gespeichert werden,
im Schritt c) eine auf einen allfälligen Erdschluß zurückzuführende Leitungsfehleradmittanz anhand einer vektoriellen Messung des Summenstromes des Leitungsabgangs unter Zugrundelegung der Referenzwerte ermittelt wird, und daß in weiteren Schritten

f) aus jeder Leitungsfehleradmittanz ein über diese fließender Leitungsfehlerwirkstrom ermittelt wird und

g) der Leitungsabgang mit dem größten Leitungsfehlerwirkstrom als erdschlußbehafteter Leitungsabgang angezeigt wird.

Die Erfindung schafft auch in diesem Aspekt eine neue Art von Erkennungskriterium, welche auf einer direkten Bewertung der Fehlerwirkströme der einzelnen Leitungsabgänge beruht. So ist es z.B. aus der EP 0 812 427 bekannt, den Leitungsabgang mit der größten Leitungsfehleradmittanz als erdschlußbehaftet anzuzeigen, mit dem Nachteil, daß manuelle Suchschaltungen dieses Kriterium beeinflussen können. Im Gegensatz dazu arbeitet das erfindungsgemäße Verfahren auch während manueller Suchschaltungen, die ein Schließen von Leitungsringen bzw. Auftrennen von Leitungen umfassen, davon unbeeinflußt richtig.

Eine besonders vorteilhafte Verfahrensvariante besteht darin, daß nur dann, wenn die Summe der Leitungsfehlerwirkströme dem über die Netzfehleradmittanz fließenden Netzfehlerwirkstrom innerhalb von Toleranzen entspricht, der Leitungsabgang mit dem größten Fehlerwirkstrom als erdschlußbehafteter Leitungsabgang angezeigt wird. Dadurch ist das Verfahren der Erfindung auch in Drehstromnetzen einsetzbar, bei welchen nicht alle Leitungsabgänge mit einem Nullstromwandler versehen sind, d.h. nicht alle Leitungsabgänge überwacht werden. Da das Verfahren der Erfindung auch in diesem Fall eindeutig anzeigen kann, ob im gesamten Drehstromnetz ein Erdschluß vorliegt, ermöglicht das genannte Kriterium die zusätzliche Anzeige, ob der Erdschluß auf einem der überwachten Leitungsabgänge liegt oder nicht: Wenn die Summe der Leitungsfehlerwirkströme dem Netzfehlerwirkstrom nicht entspricht, muß der Erdschluß auf einem der nicht überwachten Leitungsabgänge liegen.

Ein weiteres Merkmal der Erfindung besteht darin, daß im Schritt c) auch dann, wenn eine der Leitungsfehleradmittanzen einen vorgegebenen vierten Betrag überschreitet, zu Schritt d) übergegangen wird. Dadurch kann auch in dem Fall, daß zwar die vorläufige Schätzung der Netzfehleradmittanz (noch) keinen Erdschluß anzeigt, jedoch die Leitungsfehleradmittanz eines Leitungsabganges bereits "ausschlägt", eine Verifizierung der Netzparameter und der Netzfehleradmittanz im Schritt d) eingeleitet werden; deren Ergebnis kann beispielsweise sein, daß die im Zuge der Verifizierung neuermittelte Netzfehleradmittanz doch dem Auslösekriterium genügt. Die Empfindlichkeit und Zuverlässigkeit des Verfahrens der Erfindung kann damit weiter gesteigert werden.

Die Erfindung wird nachstehend anhand eines in den beigeschlossenen Zeichnungen dargestellten Ausführungsbeispieles näher erläutert. In den Zeichnungen zeigt

Fig. 1 das Blockschaltbild einer Meßanordnung zur Durchführung des erfindungsgemäßen Verfahrens in Verbindung mit einem Drehstromnetz,

die Fig. 2a und 2b das durch Anwendung des Verfahrens der symmetrischen Komponenten gewonnene, vereinfachte Ersatzschaltbild des Drehstromnetzes von Fig. 1 im erdschlußfreien und im erdschlußbehafteten Fall,

die Fig. 3a und 3b ein in gleicher Weise gewonnenes Ersatzschaltbild für einen einzelnen Leitungsabgang im erdschlußfreien und erdschlußbehafteten Fall, und

Fig. 4 ein Flußdiagramm des erfindungsgemäßen Verfahrens.

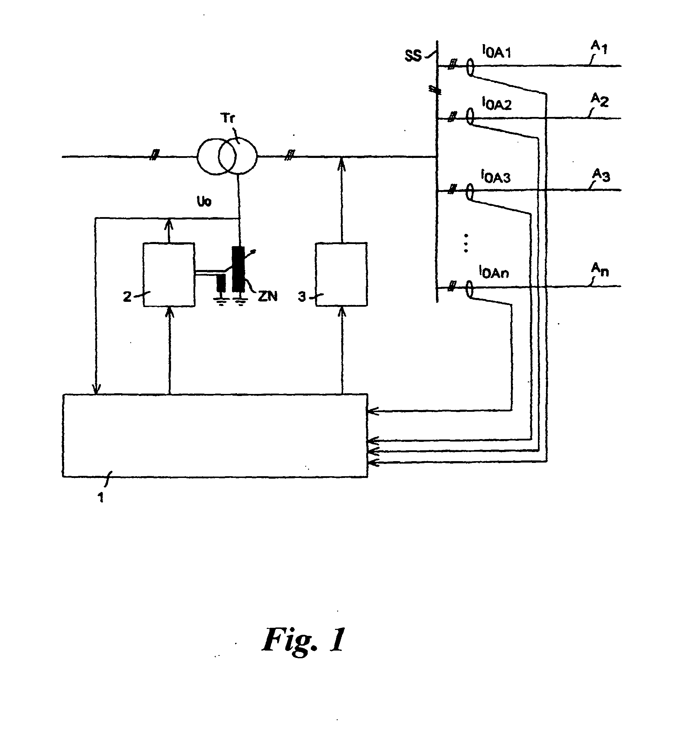

Fig. 1 zeigt die bei dem Verfahren der Erfindung zum Einsatz kommende Meßanordnung in Verbindung mit einem Drehstromnetz, welches einen Transformator Tr, eine Sammelschiene SS und mehrere Leitungsabgänge $A_n$ umfaßt. Der Sternpunkt des Transformators ist über eine Erdschlußlöschspule ZN geerdet (Petersen-Spule). Die an der Erdschlußlöschspule ZN auftretende Verlagerungsspannung $U_o$ wird vektoriell, d.h. nach Betrag und Phase bzw. Real- und Imaginärteil, gemessen und einer Meß- und Steuereinrichtung 1 zugeführt. An den Leitungsabgängen $A_n$ werden jeweils die Nullströme bzw. Summenströme $I_{o\_n}$ ebenfalls vektoriell gemessen und der Meß- und Steuereinrichtung 1 zugeführt.

Die Meß- und Steuereinrichtung 1 steuert eine Einrichtung 2 zur Änderung der Impedanz der Erdschlußlöschspule ZN und/oder eine Einrichtung 3 zur zusätzlichen Beschaltung des Sternpunktes und/oder einer der Phasen des Drehstromnetzes, um eine vorübergehende Änderung der Verlagerungsspannung $U_o$ zu bewirken. Beispielsweise kann die Impedanz der Erdschlußlöschspule ZN direkt durch Verstellen des Luftspaltes verändert werden, oder die Sekundärseite der Erdschlußlöschspule mit einem ohmschen Widerstand, einer Induktivität, einem Kondensator oder einer definierten Stromeinspeisung beschaltet werden, was durch die Einrichtung 2 angedeutet ist, und/oder es kann der Sternpunkt oder eine Phase L1, L2 oder L3 mit einem ohmschen Widerstand, einer Induktivität, einem Kondensator oder einer definierten Stromeinspeisung beschaltet werden, wie es durch die Einrichtung 3 angedeutet ist. Derartige Maßnahmen bzw. Einrichtungen sind dem Fachmann bekannt, so daß sie nicht näher erläutert oder dargestellt werden müssen.

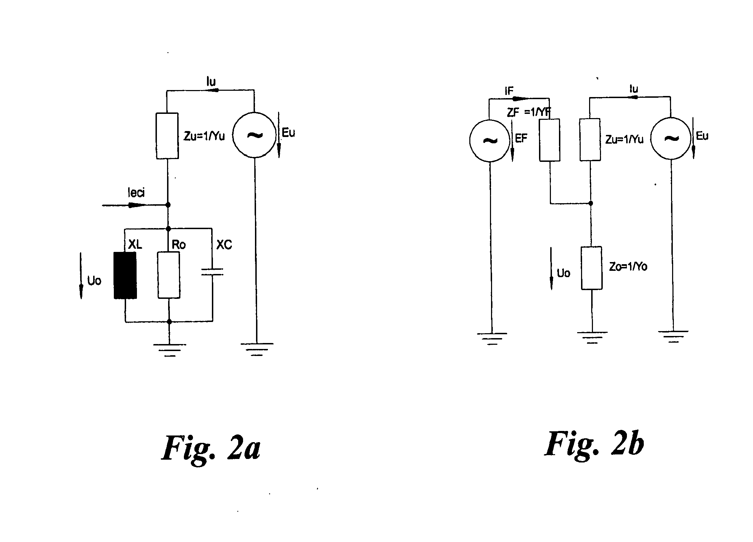

Wie Fig. 2a zeigt, kann eine allfällige Unsymmetrie des Drehstromnetzes, welche zum Auftreten einer Verlagerungsspannung $U_o$ an der Erdschlußlöschspule ZN führt, in einem vereinfachten Nullsystem-Ersatzschaltbild als treibende Unsymmetriespannung $E_u$ aufgefaßt werden, die über eine Netzunsymmetrieadmittanz $Y_u$ einen Parallelschwingkreis aus der Induktivität L der Erdschlußlöschspule ZN und der Kapazität C der Erdkapazitäten aller Leitungs-

abgänge $A_n$ speist, welcher mit den ohmschen Netzverlusten $R_o$ bedämpft ist. Die Komponenten L, C und $R_o$ können zu einer Netznulladmittanz $Y_o$ zusammengefaßt werden (siehe auch Fig. 2b), welche gemeinsam mit der Netzunsymmetrieadmittanz $Y_u$ und der zugehörigen treibenden Unsymmetriespannung $E_u$ die "globalen" Netzparameter des Drehstromnetzes bilden.

In Kenntnis der globalen Netzparameter $Y_u$, $Y_o$ und $E_u$ kann ein auf einem (oder auch mehreren) Leitungsabgängen An des Drehstromnetzes auftretender einphasiger (oder auch zweiphasiger) Erdschluß als treibende Fehlerspannung $E_F$ aufgefaßt werden, die über eine Netzfehleradmittanz $Y_F$ den Sternpunkt speist, genauer die Netznulladmittanz $Y_o$, wie in Fig. 2b dargestellt.

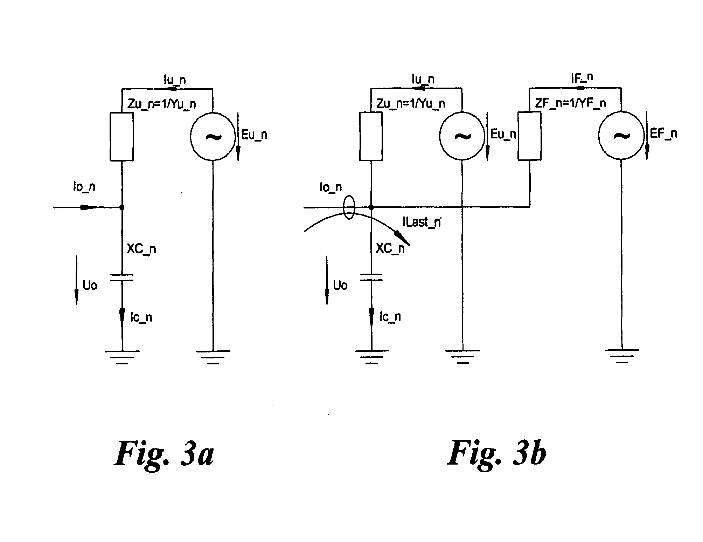

In ähnlicher Weise kann das Nullsystem eines einzelnen Leitungsabganges $A_n$, wenn er einer Unsymmetrie unterworfen ist, gemäß Fig. 3a als treibende Leitungsunsymmetriespannung $E_{u\_n}$ abgebildet werden, welche über eine Leitungsunsymmetrieadmittanz $Y_{u\_n}$ gemeinsam mit dem Summenstrom $I_{o\_n}$ des Leitungsabganges An die Leitungserdadmittanz $Y_{c\_n}$ (bzw. Leitungserdimpedanz $X_{c\_n}$) des Leitungsabganges $A_n$ speist. In einem in Fig. 3b gezeigten Erdschlußfall kann dies durch eine zusätzliche Speisung von einer treibenden Leitungsfehlerspannung $E_{F\_n}$ über eine Leitungsfehleradmittanz $Y_{F\_n}$ dargestellt werden.

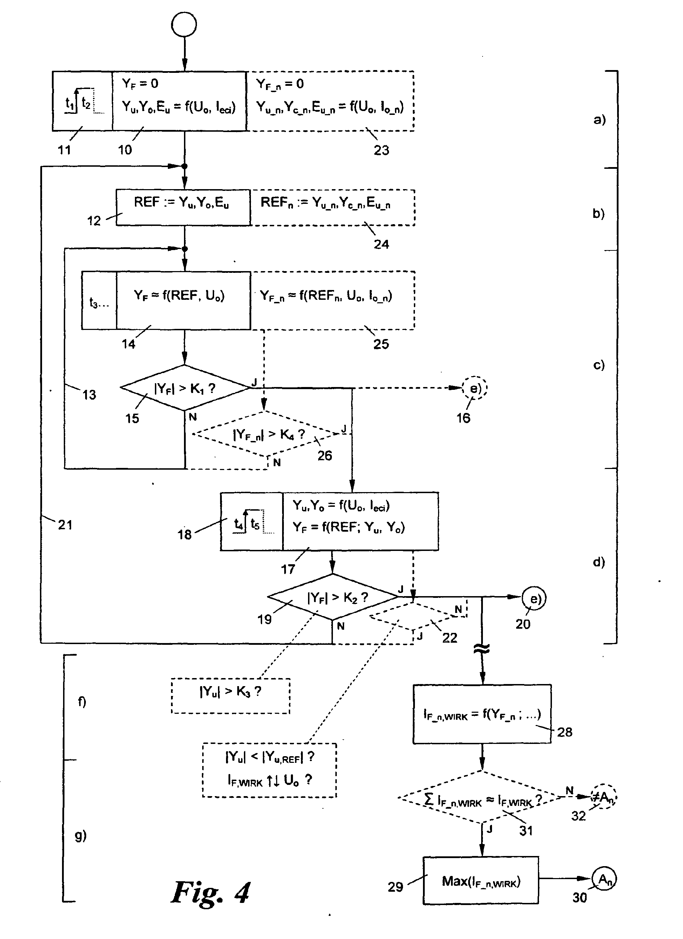

Das Verfahren der Erfindung wird nun anhand des Flußdiagramms von Fig. 4 ausführlicher erörtert, wobei die Ersatzschaltbilder der Fig. 2a, 2b, 3a und 3b zugrunde gelegt werden.

In einem ersten Schritt a) werden im Block 10 zunächst die globalen Netzparameter des Drehstromnetzes ermittelt, und zwar die Netzunsymmetrieadmittanz $Y_u$, die Netznulladmittanz $Y_o$ und die treibende Unsymmetriespanung $E_u$. Zu diesem Zweck wird der Sternpunkt des Drehstromnetzes im Block 11 temporär beaufschlagt. Dies kann entweder durch direkte Einspeisung eines Stromes $I_{eci}$ in den Sternpunkt durchgeführt werden oder durch eine Verstimmung der Netznulladmittanz $Y_o$, welche bei bekannten Komponenten L, $R_o$ und C in einen (fiktiven) Einspeisestrom $I_{eci}$ umgerechnet werden kann. Die Verlagerungsspannung $U_o$ des Sternpunktes wird zu einem Zeitpunkt $t_1$ vor der Beaufschlagung des Sternpunktes und zu einem zweiten Zeitpunkt $t_2$ während der Beaufschlagung eines Sternpunktes vektoriell gemessen und aus den beiden komplexen Meßwerten $U_o(t_1)$ und $U_o(t_2)$ und der bekannten Verstimmung bzw. Einspeisung $I_{eci}$ können die Netzparameter $Y_o$, $Y_u$ und $E_u$ ermittelt werden. Gleichzeitig wird in Block 10 angenommen, daß die Netzfehleradmittanz $Y_F$ null ist.

In einem anschließenden Schritt b) werden im Block 12 die Netzparameter $Y_u$, $Y_o$ und $E_u$ als Referenzwerte REF gespeichert.

Es versteht sich, daß anstelle einer Speicherung der Netzparameter $Y_u$, $Y_o$ und $E_u$ auch die diesen zugrundeliegenden Werte gespeichert werden können, wie die Daten der temporären Beaufschlagung des Sternpunktes, z.B. Spulenverstimmung, Einspeisestrom $I_{eci}$ usw., und der dabei auftretenden Verlagerungsspannungen $U_o(t_1)$, $U_o(t_2)$ usw., da aus diesen die Netzparameter $Y_u$, $Y_o$ und $E_u$ jederzeit - d.h. in jedem späteren Verfahrensschritt wie den Schritten b), c) und/oder d) - berechnet werden können; eine derartige Vorgehensweise ist für den Fachmann äquivalent zu dem in Fig. 4 gezeigten Ablauf.

In einem weiteren Schritt c), welcher auch in Form einer Schleife 13 kontinuierlich bzw. periodisch durchlaufen werden kann, wird nun die jeweils aktuelle Verlagerungsspannung $U_o$ vektoriell gemessen und daraus unter Zugrundelegung des Ersatzschaltbildes Fig. 2b eine allfällig auftretende Netzfehleradmittanz $Y_F$ ermittelt (Block 14). Dazu wird zweckmäßigerweise die Annahme herangezogen, daß die Netzfehleradmittanz reell ist. Die ermittelte Netzfehleradmittanz $Y_F$ kann in einem optionalen, weiter unten erörterten Verfahrensschritt d) weiter verifiziert werden, in welchem Fall ihre Ermittlung im Schritt c) als eine erste Schätzung der Netzfehleradmittanz $Y_F$ bezeichnet werden kann.

In der anschließenden Verzweigung 15 wird überprüft, ob der Betrag der (geschätzten) Netzfehleradmittanz $Y_F$ einen vorgegebenen ersten Betrag $K_1$ überschreitet. Wenn ja, könnte in einer vereinfachten Variante des Verfahrens bereits in einem Schritt e) ein Erdschluß angezeigt werden (Zustand 16). Wenn nein, könnte das Verfahren enden, bevorzugt wird aber über die Schleife 13 wieder mit Schritt c) begonnen.

Anstelle des direkten Überganges zu Schritt e) (Zustand 16) kann in dem Fall, daß die Verzweigung 15 mit ja entschieden wird, auch zum optionalen Schritt d) verzweigt werden. Im Schritt d) wird im Block 17 zunächst die Ermittlung der Netzparameter $Y_u$, $Y_o$ und optional $E_u$ wiederholt, und zwar durch erneute Beaufschlagung des Sternpunktes im Block 18, um zwei Arbeitspunkte zu den Zeitpunkten $t_4$ und $t_5$ zu erhalten.

Die im Block 17 neu ermittelten Netzparameter, insbesondere $Y_u$ und $Y_o$, können mit den zuvor ermittelten, als Referenzwerte REF gespeicherten Netzparametern verglichen und daraus die Netzfehleradmittanz $Y_F$ genauer bzw. neu bestimmt werden: Zeigt der Vergleich der neu ermittelten Netzparametern mit den gespeicherten Netzparametern, daß sich überwiegend die Netznulladmittanz $Y_o$ geändert hat, liegt offensichtlich kein Erdschluß vor, sondern das Zuoder Abschalten eines die Erdadmittanz verändernden Leitungsabschnittes. In diesem Fall ist die neu ermittelte bzw. "verifizierte" Netzfehleradmittanz $Y_F$ - im Gegensatz zu der im Schritt c) "geschätzten" - im wesentlichen null. Hat sich anderseits die neu ermittelte Netznulladmittanz $Y_o$ gegenüber den gespeicherten Referenzwerten kaum verändert, liegt offensichtlich tatsächlich ein Erdschluß vor, welcher zu der Netzfehleradmittanz $Y_F$ geführt hat; diese ist damit "verifiziert".

In der anschließenden Verzweigung 19 im Schritt d) wird überprüft, ob die (verifizierte) Netzfehleradmittanz $Y_F$ einen vorgegebenen zweiten Betrag $K_2$ überschreitet, welcher bevorzugt gleich groß ist wie der erste Betrag $K_1$.

Wenn ja, wird wieder zu Schritt e) und der Anzeige eines Erdschlusses übergegangen (Zustand 20).

Wenn die verifizierte Netzfehleradmittanz $Y_F$ den zweiten Betrag $K_2$ in der Verzweigung 19 nicht überschreitet, d.h. sich offensichtlich die Netzunsymmetrieadmittanz $Y_u$ und/oder die Netznulladmittanz $Y_o$ verändert haben, kehrt bevorzugt das Verfahren über die Schleife 21 zu Schritt b) zurück, d.h. die soeben ermittelten Netzparameter $Y_u$ und $Y_o$ und optional $E_u$ werden als neue Referenzwerte REF gespeichert. Auf diese Weise wird das Netzmodell aktualisiert und an allfällige Schaltvorgänge im Netz angepaßt.

In der Verzweigung 19 des Schrittes d) kann optional auch dann zu der Erdschlußanzeige im Schritt e) übergegangen werden, wenn die neu ermittelte Netzunsymmetrieadmittanz $Y_u$ einen vorgegebenen dritten Betrag $K_3$ ($K_3 > K_1$; $K_3 > K_2$) überschreitet, welcher ein Auslösekriterium für die Anzeige eines niederohmigen Erdschlusses darstellt.

Mit der optionalen Verzweigung 22 in Schritt d) sind zwei zu der Verzweigung 19 alternative Situationen angegeben, in welchen jeweils eine Aktualisierung des Netzmodells, d.h. Referenzwertübernahme in Schritt b), eingeleitet werden kann. Zum einen kann die Schleife 21 zur Referenzwertübernahme in Schritt b) beschritten werden, wenn die neu ermittelte Netzunsymmetrieadmittanz $Y_u$ kleiner ist als ihr entsprechender Referenzwert $Y_{u\_REF}$, d.h. die globale Netzunsymmetrieadmittanz $Y_u$ offensichtlich kleiner geworden ist. Dies deutet darauf hin, daß das Verfahren offensichtlich zum Zeitpunkt eines temporären Erdschlusses begonnen worden war, welcher zwischenzeitlich aufgehört hat, sodaß nunmehr die Referenzwerte REF anzupassen sind.

Zum anderen kann alternativ die Referenzwertübernahme des Schrittes b) auch dann veranlaßt werden, wenn der über die Netzfehleradmittanz $Y_F$ fließende Netzfehlerwirkstrom $I_{F,WIRK}$ (Fig. 2b) in Bezug auf die Verlagerungsspannung $U_o$ negativ ist, was ebenfalls auf einen derartigen Fall hinweist.

Die bislang erörterten Verfahrensschritte a) bis e) verkörpern den Teil des Verfahrens, welcher sich mit der Anzeige eines Erdschlusses befaßt. Die nun erörterten fakultativen Schritte f) und g) befassen sich mit der Erkennung und Anzeige jenes Leitungsabganges $A_n$, welcher tatsächlich von dem Erdschluß befallen ist. Dafür ist eine entsprechende Ergänzung der Verfahrensschritte a) bis d) erforderlich (siehe Blöcke 23 bis 26), wie nun im einzelnen erörtert wird.

So können im Zuge des Schrittes a) im Block 23 für jeden Leitungsabgang $A_n$ auf Grundlage des Ersatzschaltbildes Fig. 3a durch Messung der Verlagerungsspannung $U_o$ und des Summenstromes bzw. Nullstromes $I_{o\_n}$ des jeweiligen Abganges An die Leitungsunsymmetrieadmittanz $Y_{u\_n}$, die Leitungserdadmittanz $Y_{c\_n}$ (bzw. Impedanz $X_{c\_n}$) und die jeweilige treibende Unsymmetriespannung $E_{u\_n}$ als abgangsspezifische, d.h. "lokale" Leitungsparameter ermittelt werden. Im Schritt b) werden die Leitungsparameter $Y_{u\_n}$, $Y_{c\_n}$, $E_{u\_n}$ als abgangsspezifische Referenzwerte $REF_n$ gespeichert (Block 24).

Falls gewünscht, kann im Schritt c) für jeden Abgang $A_n$ eine (geschätzte) Leitungsfehleradmittanz $Y_{F\_n}$ anhand der gespeicherten Referenzwerte $REF_n$ und einer aktuellen vektoriellen Messung der Verlagerungsspannung $U_o$ und des Summenstromen $I_{o\_n}$ des Leitungsabganges $A_n$ unter Zugrundelegung des Ersatzschaltbildes Fig. 3b ermittelt werden, wobei die treibende Leitungsfehlerspannung $E_{F\_n}$ vorzugsweise der treibenden Netzfehlerspannung $E_F$ gleichgesetzt wird (Block 25).

In einer optionalen Verzweigung 26 kann überprüft werden, ob eine der Leitungsfehleradmittanzen $Y_{F\_n}$ einen vorgegebenen vierten Betrag $K_4$ überschreitet. Wenn ja, kann dies ebenfalls als Auslösekriterium zur Verifizierung in Schritt d) verwendet werden. Ein solches Auslösen einer der Leitungsfehleradmittanzen $Y_{F\_n}$ kann jedoch niemals direkt zur Anzeige eines Erdschlusses führen, sondern stets nur zum Eintritt in den Schritt d).

Damit stehen für die Erkennung des erdschlußbehafteten Abganges die Leitungsfehleradmittanzen $Y_{F\_n}$ als Grundlage zur Verfügung.

In einem Schritt f) werden nun im Block 28 aus den Leitungsfehleradmittanzen $Y_{F\_n}$ unter Zugrundelegung der Leitungsparameter bzw. Referenzwerte $REF_n$ und des Ersatzschaltbildes von Fig. 3b die über die jeweiligen Leitungsfehleradmittanzen $Y_{F\_n}$ fließenden Leitungsfehlerströme $I_{F\_n}$ und daraus die reellen Leitungsfehlerwirkströme $I_{F\_n,WIRK}$ ermittelt, u.zw. gemäß

$$I_{F\_n,WIRK} = real\left( conj(I_{F\_n}) \cdot \frac{Uo}{|Uo|} \right)$$

In einem anschließenden Schritt g) wird der Leitungsabgang $A_n$ mit dem größten Leitungsfehlerwirkstrom $I_{F\_n,WIRK}$ gesucht (Block 29) und als erdschlußbehafteter Leitungsabgang $A_n$ angezeigt (Zustand 30).

Optional kann im Schritt g) vor dem Block 29 in einer Verzweigung 31 überprüft werden, ob die Summe der Leitungsfehlerwirkströme $I_{F\_n,WIRK}$ dem über die Netzfehleradmittanz $Y_F$ fließenden Netzfehlerwirkstrom $I_{F,WIRK}$ (Fig. 2b) innerhalb von Toleranzgrenzen entspricht, beispielsweise diese Summe zumindest 70 % von $I_{F,WIRK}$ erreicht:

$$\sum I_{F\_n,WIRK} \approx I_{F,WIRK}$$

Wenn ja, wird zum Block 29 und der Suche des maximalen Leitungsfehlerwirkstromes $I_{F\_n,WIRK}$ verzweigt. Wenn nein, bedeutet dies, daß der Erdschluß offensichtlich auf einem nicht zum überwachten System gehörenden Leitungsabgang liegt, d.h. auf einem Leitungsabgang, dessen Summenstrom $I_{o\_n}$ nicht gemessen wird. In diesem Fall wird zum Zustand 32 verzweigt und eine entsprechende Anzeige generiert.

Die Erfindung ist nicht auf die dargestellten Ausführungsbeispiele beschränkt, sondern umfaßt alle Varianten und Modifikationen, die in den Rahmen der angeschlossenen Ansprüche fallen.

**Patentansprüche**

1.  Verfahren zum Anzeigen eines hochohmigen Erdschlusses in einem Drehstromnetz mit zumindest zwei Leitungsabgängen, das mit einer Erdschlußlöschspule zur Resonanzerdung des Sternpunktes betrieben wird, mit den Schritten:

    a) Ermitteln von Netzparametern umfassend zumindest eine auf die Unsymmetrie aller Leitungsabgänge ($A_1$, $A_2$..) zurückzuführende Netzunsymmetrieadmittanz ($Y_u$) und eine die Erdkapazität aller Leitungsabgänge ($A_1$, $A_2$..) berücksichtigende Netznulladmittanz ($Y_o$) anhand einer temporären Beaufschlagung des Sternpunktes und vektoriellen Messung seiner Verlagerungsspannung ($U_o$),
    b) Speichern der Netzparameter ($Y_u$, $Y_o$, $E_u$) oder der diesen zugrundeliegenden Werte ($I_{eci}$, $U_o$) als Referenzwerte (REF),
    c) Ermitteln einer auf einen allfälligen Erdschluß zurückzuführenden Netzfehleradmittanz ($Y_F$) anhand einer vektoriellen Messung der Verlagerungsspannung ($U_o$) unter Zugrundelegung der Referenzwerte (REF) und, wenn die Netzfehleradmittanz ($Y_F$) einen vorgegebenen ersten Betrag ($K_1$) überschreitet,
    e) Anzeigen eines Erdschlusses.

2.  Verfahren nach Anspruch 1, **dadurch gekennzeichnet, daß**, wenn die Netzfehleradmittanz ($Y_F$) im Schritt c) den vorgegebenen ersten Betrag ($K_1$) nicht überschreitet, das Verfahren ab Schritt c) wiederholt wird.

3.  Verfahren nach Anspruch 1 oder 2, **dadurch gekennzeichnet, daß** nach Schritt c), wenn im Schritt c) die Netzfehleradmittanz ($Y_F$) den vorgegebenen ersten Betrag ($K_1$) überschreitet, nur über den zusätzlichen Schritt:

    d) neuerliches Ermitteln der Netzparameter ($Y_u$, $Y_o$, $E_u$) und der Netzfehleradmittanz ($Y_F$) anhand einer neuerlichen temporären Beaufschlagung des Sternpunktes und vektoriellen Messung seiner Verlagerungsspannung ($U_o$) und eines Vergleichs mit den Referenzwerten (REF) und, wenn die Netzfehleradmittanz ($Y_F$) einen vorgegebenen zweiten Betrag ($K_2$) überschreitet,
    zu Schritt e) übergegangen wird.

4.  Verfahren nach Anspruch 3, **dadurch gekennzeichnet, daß** auch dann, wenn im Schritt d) die Netzunsymmetrieadmittanz ($Y_u$) einen vorgegebenen dritten Betrag ($K_3$) überschreitet, zu Schritt e) übergegangen wird.

5.  Verfahren nach Anspruch 3 oder 4, **dadurch gekennzeichnet, daß**, wenn im Schritt d) die Netzfehleradmittanz ($Y_F$) - und gegebenenfalls die Netzunsymmetrieadmittanz ($Y_u$) - ihre vorgegebenen zweiten bzw. dritten Beträge ($K_2$, $K_3$) nicht überschreiten, das Verfahren ab Schritt b) wiederholt wird.

6.  Verfahren nach Anspruch 5, **dadurch gekennzeichnet, daß** auch dann, wenn im Schritt d) die Netzunsymmetrieadmittanz ($Y_u$) kleiner ist als ihr Referenzwert ($Y_{u,REF}$), das Verfahren ab Schritt b) wiederholt wird.

7.  Verfahren nach Anspruch 5 oder 6, **dadurch gekennzeichnet, daß** der über die Netzfehleradmittanz ($Y_F$) fließende Netzfehlerwirkstrom ($I_{F,WIRK}$) ermittelt wird und
    auch dann, wenn im Schritt d) der Netzfehlerwirkstrom ($I_{F,WIRK}$) in Bezug auf die Verlagerungsspannung ($U_o$) negativ ist, das Verfahren ab Schritt b) wiederholt wird.

8.  Verfahren nach einem der Ansprüche 1 bis 7 ferner zur Anzeige des erdschlußbehafteten Leitungsabgangs, **dadurch**

**gekennzeichnet, daß** für jeden einzelnen Leitungsabgang ($A_n$):

im Schritt a) Leitungsparameter umfassend jeweils zumindest eine auf die Unsymmetrie des Leitungsabgangs zurückzuführende Leitungsunsymmetrieadmittanz ($Y_{u\_n}$) anhand der temporären Beaufschlagung des Sternpunktes und einer vektoriellen Messung des Summenstromes ($I_{o\_n}$) des Leitungsabgangs (An) ermittelt werden,
im Schritt b) die Leitungsparameter ($Y_{u\_n}$, $Y_{c\_n}$, $E_{u\_n}$) als Referenzwerte ($REF_n$) gespeichert werden,
im Schritt c) eine auf einen allfälligen Erdschluß zurückzuführende Leitungsfehleradmittanz ($Y_{F\_n}$) anhand einer vektoriellen Messung des Summenstromes ($I_{o\_n}$) des Leitungsabgangs ($A_n$) unter Zugrundelegung der Referenzwerte ($REF_n$) ermittelt wird,
und daß in weiteren Schritten
f) aus jeder Leitungsfehleradmittanz ($Y_{F\_n}$) ein über diese fließender Leitungsfehlerwirkstrom ($I_{F\_n,WIRK}$) ermittelt wird und
g) der Leitungsabgang ($A_n$) mit dem größten Leitungsfehlerwirkstrom ($I_{F\_n,WIRK}$) als erdschlußbehafteter Leitungsabgang angezeigt wird.

9. Verfahren nach Anspruch 8, **dadurch gekennzeichnet, daß** nur dann, wenn die Summe der Leitungsfehlerwirkströme ($I_{F\_n,WIRK}$) dem über die Netzfehleradmittanz ($Y_F$) fließenden Netzfehlerwirkstrom ($I_{F,WIRK}$) innerhalb von Toleranzen entspricht, der Leitungsabgang ($A_n$) mit dem größten Fehlerwirkstrom ($I_{F\_n,WIRK}$) als erdschlußbehafteter Leitungsabgang angezeigt wird.

10. Verfahren nach Anspruch 8 oder 9, **dadurch gekennzeichnet, daß** im Schritt c) auch dann, wenn eine der Leitungsfehleradmittanzen ($Y_{F\_n}$) einen vorgegebenen vierten Betrag ($K_4$) überschreitet, zu Schritt d) übergegangen wird.

**Claims**

1. A method of indicating a high-resistance earth fault in a three-phase network having at least two line outlets, which network is operated with an earth-fault neutraliser for resonant earthing of the star point, having the steps of:

a) determining network parameters including at least one network asymmetric admittance ($Y_u$) attributable to the asymmetry of all the line outlets ($A_1$, $A_2$, etc.) and a network zero admittance ($Y_o$) taking account of the earth capacitance of all the line outlets ($A_1$, $A_2$ etc.), by acting temporarily on the star point and by vector measurement of the displacement voltage ($U_o$) thereof,
b) storing as reference values (REF) the network parameters ($Y_u$, $Y_o$, $E_u$) or the values ($I_{eci}$, $U_o$) on which these are based,
c) determining a network error admittance ($Y_F$) attributable to a possible earth fault by vector measurement of the displacement voltage ($U_o$) on the basis of the reference values (REF) and, if the network error admittance ($Y_F$) exceeds a predetermined first amount ($K_1$),
e) indicating an earth fault.

2. A method according to claim 1, **characterised in that** the method is repeated from step c) if the network error admittance ($Y_F$) in step c) does not exceed the predetermined first amount ($K_1$).

3. A method according to claim 1 or claim 2, **characterised in that**, after step c), if the network error admittance ($Y_F$) exceeds the predetermined first amount ($K_1$) in step c), the additional step is performed of:

d) again determining the network parameters ($Y_u$, $Y_o$, $E_u$) and the network error admittance ($Y_F$) by again acting temporarily on the star point and by vector measurement of the displacement voltage ($U_o$) thereof and comparison with the reference values (REF) and, if the network error admittance ($Y_F$) exceeds a predetermined second amount ($K_2$),

only then is step e) proceeded to.

4. A method according to claim 3, **characterised in that** step e) is proceeded to even when, in step d), the network asymmetric admittance ($Y_u$) exceeds a predetermined third amount ($K_3$).

5. A method according to claim 3 or claim 4, **characterised in that** if, in step d), the network error admittance ($Y_F$),

and optionally the network asymmetric admittance ($Y_u$), do not exceed their respective predetermined second or third amounts ($K_2$, $K_3$), the method is repeated from step b).

6. A method according to claim 5, **characterised in that** the method is repeated from step b) even when, in step d), the network asymmetric admittance ($Y_u$) is lower than its reference value ($Y_{u,REF}$).

7. A method according to claim 5 or claim 6, **characterised in that** the network error active current ($I_{F,WIRK}$) flowing through the network error admittance ($Y_F$) is determined and
even when the network error active current ($I_{F,WIRK}$) is negative in step d) relative to the displacement voltage ($U_o$), the method is repeated from step b).

8. A method according to any one of claims 1 to 7 additionally for indicating the line outlet affected by the earth fault, **characterised in that** for each individual line outlet ($A_n$):

   in step a) line parameters including in each case at least one line asymmetric admittance ($Y_{u\_n}$) attributable to the asymmetry of the line outlet are determined by acting temporarily on the star point and by vector measurement of the total current ($I_{o\_n}$) of the line outlet ($A_n$),
   in step b) the line parameters ($Y_{u\_n}$, $Y_{c\_n}$, $E_{u\_n}$) are stored as reference values ($REF_n$),
   in step c) a line error admittance ($Y_{F\_n}$) attributable to a possible earth fault is determined by vector measurement of the total current ($I_{o\_n}$) of the line outlet (An) on the basis of the reference values ($REF_n$),
   and **in that** in further steps
   f) a line error active current ($I_{F\_n,WIRK}$) flowing through each line error admittance ($Y_{F\_n}$) is determined therefrom and
   g) the line outlet (An) with the greatest line error active current ($I_{F\_n,WIRK}$) is indicated as the line outlet affected by the earth fault.

9. A method according to claim 8, **characterised in that** the line outlet ($A_n$) with the greatest error active current ($I_{F\_n,WIRK}$) is indicated as the line outlet affected by an earth fault only when the sum of the line error active currents ($I_{F\_n,WIRK}$) corresponds within tolerances to the network error active current ($I_{F,WIRK}$) flowing through the network error admittance ($Y_F$).

10. A method according to claim 8 or claim 9, **characterised in that** in step c), step d) is proceeded to even when one of the line error admittances ($Y_{F\_n}$) exceeds a predetermined fourth amount ($K_4$).

## Revendications

1. Procédé d'affichage d'un défaut à la terre à grande résistance dans un réseau triphasé avec au moins deux départs de connexion, qui fonctionne avec une bobine Petersen pour la mise à la terre à résonance du point neutre, comprenant les étapes consistant à :

   a) déterminer des paramètres réseau comprenant au moins une admittance de dissymétrie du réseau ($Y_u$) à imputer à la dissymétrie de tous les départs de connexion ($A_1$, $A_2$...) et une admittance nulle de réseau ($Y_0$) tenant compte de la capacitance à la terre de tous les départs de connexion ($A_1$, $A_2$...) au moyen d'une admission temporaire du point neutre et de la mesure vectorielle de sa tension de déplacement ($U_0$),
   b) enregistrer des paramètres réseau ($Y_u$, $Y_0$, $E_u$) ou des valeurs à la base de ces paramètres ($I_{eci}$, $U_0$) en tant que valeurs de référence (REF),
   c) déterminer une admittance d'erreur réseau ($Y_F$) à imputer à un éventuel défaut à la terre au moyen d'une mesure vectorielle de la tension de déplacement ($U_o$) en s'appuyant sur les valeurs de référence (REF) et, lorsque l'admittance d'erreur réseau ($Y_F$) dépasse un premier seuil prédéfini ($K_1$),
   e) afficher un défaut à la terre.

2. Procédé selon la revendication 1, **caractérisé en ce que**, lorsque, à l'étape c), l'admittance d'erreur réseau ($Y_F$) ne dépasse pas le premier seuil prédéfini ($K_1$), le procédé est répétée à partir de l'étape c).

3. Procédé selon la revendication 1 ou 2, **caractérisé en ce qu'**après l'étape c), seulement lorsqu'à l'étape c) l'admittance d'erreur réseau ($Y_F$) dépasse le premier seuil prédéfini ($K_1$), on passe à l'étape supplémentaire consistant à :

d) déterminer à nouveau des paramètres réseau ($Y_u$, $Y_0$, $E_u$) et de l'admittance d'erreur réseau ($Y_F$) au moyen d'une nouvelle admission temporaire du point neutre et de la mesure vectorielle de sa tension de déplacement ($U_0$) et d'une comparaison avec les valeurs de référence (REF) et, lorsque l'admittance d'erreur réseau ($Y_F$) dépasse un deuxième seuil prédéfini ($K_2$), on passe à l'étape e).

4. Procédé selon la revendication 3, **caractérisé en ce qu'**ensuite également, lorsqu'à l'étape d) l'admittance de dissymétrie du réseau ($Y_u$) dépasse un troisième seuil prédéfini ($K_3$), on passe à l'étape e).

5. Procédé selon la revendication 3 ou 4, **caractérisé en ce que**, lorsqu'à l'étape d) l'admittance d'erreur réseau ($Y_F$) - et, le cas échéant, l'admittance de dissymétrie du réseau ($Y_u$) - ne dépasse pas son deuxième et/ou troisième seuil prédéfini ($K_2$, $K_3$), le procédé est répété à partir de l'étape b).

6. Procédé selon la revendication 5, **caractérisé en ce qu'**ensuite également, lorsqu'à l'étape d) l'admittance de déséquilibre réseau ($Y_u$) est inférieure à sa valeur de référence ($Y_{u,REF}$), la procédé est répété à partir de l'étape b).

7. Procédé selon la revendication 5 ou 6, **caractérisé en ce que** le courant actif ($I_{F,WIRK}$) de l'erreur réseau traversant l'admittance d'erreur réseau ($Y_F$) est déterminé et
également, lorsqu'à l'étape d) le courant actif de l'erreur réseau ($I_{F,WIRK}$) en ce qui concerne la tension de déplacement ($U_0$) est négatif, le procédé est répété à partir de l'étape b).

8. Procédé selon l'une des revendications 1 à 7 permettant également d'afficher le départ de connexion présentant le défaut à la terre, **caractérisé en ce que** pour chaque départ de connexion ($A_n$) :

   à l'étape a), les paramètres de connexion, comprenant chacun au moins une admittance de dissymétrie de ligne ($Y_{u\_n}$) à imputer à la dissymétrie du départ de connexion, sont déterminés au moyen de l'admission temporaire du point neutre et de la mesure vectorielle du courant résiduel ($I_{o\_n}$) du départ de connexion ($A_n$),
   à l'étape b), les paramètres de connexion ($Y_{u\_n}$, $Y_{c\_n}$, $E_{u\_n}$) sont enregistrés en tant que valeurs de référence ($REF_n$),
   à l'étape c), une admittance d'erreur de connexion ($Y_{F\_n}$), à imputer à un éventuel défaut à la terre, est déterminée au moyen de la mesure vectorielle du courant résiduel ($I_{o\_n}$) du départ de connexion ($A_n$) sur la base des valeurs de référence ($REF_n$),
   et **en ce que** dans des étapes suivantes
   f) à partir de chaque admittance d'erreur de connexion ($Y_{F\_n}$), un courant actif d'erreur de connexion ($I_{F\_n,WIRK}$) traversant cette dernière est déterminé et
   g) le départ de connexion ($A_n$) avec le plus gros courant actif d'erreur de connexion ($I_{F\_n, WIRK}$) est affiché en tant que départ de connexion présentant un défaut à la terre.

9. Procédé selon la revendication 8, **caractérisé en ce que** seulement ensuite, lorsque la somme des courants actifs d'erreur de connexion ($I_{F\_n,WIRK}$) correspond au courant actif d'erreur de connexion ($I_{F,WIRK}$) traversant l'admittance d'erreur réseau ($Y_F$) dans les limites de tolérances, le départ de connexion ($A_n$) avec le plus gros courant actif d'erreur ($I_{F\_n,WIRK}$) est affiché en tant que départ de connexion présentant un défaut à la terre.

10. Procédé selon la revendication 8 ou 9, **caractérisé en ce qu'**ensuite également à l'étape c), lorsque l'une des admittances d'erreur de connexion ($Y_{F\_n}$) dépasse un quatrième seuil prédéfini ($K_4$), on passe à l'étape d).

*Fig. 1*

**Fig. 2b**

**Fig. 2a**

*Fig. 3b*

*Fig. 3a*

*Fig. 4*

a)
b)
c)
d)
f)
g)

$Y_F = 0$
$Y_u, Y_o, E_u = f(U_o, I_{eci})$

$Y_{F\_n} = 0$
$Y_{u\_n}, Y_{c\_n}, E_{u\_n} = f(U_o, I_{o\_n})$

$t_1$ $t_2$

11   10   23

$REF := Y_u, Y_o, E_u$   $REF_n := Y_{u\_n}, Y_{c\_n}, E_{u\_n}$

12   24

$t_3 ...$   $Y_F \approx f(REF, U_o)$   $Y_{F\_n} \approx f(REF_n, U_o, I_{o\_n})$

14   25

13

$|Y_F| > K_1$ ?   J

15   N

$|Y_{F\_n}| > K_4$ ?   J

26   N

e)

16

21

$t_4$ $t_5$   $Y_u, Y_o = f(U_o, I_{eci})$
$Y_F = f(REF; Y_u, Y_o)$

18   17

$|Y_F| > K_2$ ?   J

19   N

22   N   J

e)

20

$|Y_u| > K_3$ ?

$|Y_u| < |Y_{u,REF}|$ ?
$I_{F,WIRK} \uparrow\downarrow U_o$ ?

$I_{F\_n,WIRK} = f(Y_{F\_n} ; ...)$

28

$\sum I_{F\_n,WIRK} \approx I_{F,WIRK}$ ?   N   ≠$A_n$

31   32

J

$Max(I_{F\_n,WIRK})$   $A_n$

29   30